# EUROPEAN PATENT APPLICATION

(11) **EP 2 239 561 A1**
(43) Date of publication of application: **13.10.2010**
(21) Application number: 10450056.6
(22) Date of filing: 09.04.2010
(51) Int. Cl.: G01N 27/414, H01L 51/05

(54) **OFET-based sensor for detecting an analyte**

(30) Priority: 09.04.2009 GB 0906204
(71) Applicant: Technische Universität Graz, 8010 Graz (AT); NanoTecCenter Weiz Forschungsgesellschaft mbH, 8160 Weiz (AT)
(72) Inventor: List, Emil J. W., 8010 Graz (AT); Slugovc, Christian, 8047 Graz (AT); Klug, Andreas, 8047 Graz (AT); Denk, Martin, 8010 Graz (AT)
(74) Representative: Patentanwaltskanzlei Matschnig & Forsthuber OG

(57) **Abstract**

An electrical sensor ("SensFET") is provided for qualitatively and/or quantitatively detecting an analyte of interest (molecules, ions etc.) in a gaseous or liquid medium, comprising an organic field-effect transistor device fabricated on a rigid or flexible substrate (61) having a source electrode (63), a drain electrode (64), an organic semiconducting layer serving as active channel (65), possibly one or more intermediate layers (66), a dielectric layer (67) and a gate electrode (68). The dielectric layer includes an organic material sensitive to a volatile or dissolved analyte in said medium, being adapted to change its electrical properties upon contact with said analyte so that the organic field-effect transistor generates an electrically detectable response.

## Description

### Field of the invention and description of prior art

The present invention relates to a sensor for detecting an analyte of interest in a gaseous or liquid medium, comprising an organic field-effect transistor (OFET) which, beside a semiconductor channel connecting a source electrode and a drain electrode, has a gate electrode which is separated from said channel by a dielectric layer.

The invention is set in the field of organic field-effect transistors used as sensor device, in particular to such devices that are built from semiconducting organic materials. Such sensor devices are used to detect miscellaneous analytes such as oxygen, ammonia, alcohol vapors, ions, acids, bases, aromatic compounds or biomolecules.

Organic materials exhibit a wide range of advantages over their inorganic counterparts. They enable solution-based processing, which allows for easy, cost-effective deposition and structuring technologies such as inkjet-printing or soft lithography, as well as cheaper equipment as compared to the inorganic-based technologies. They can be processed on simple, flexible, organic, inorganic or even biological substrates at low temperatures over large areas and, by modifying the chemical structure of the organic compounds, their electrical, optical and morphological properties can be tuned.

The successful integration of semiconducting organic materials, in the form of small molecules as well as conjugated polymers, is well established in prior art and has led to a number of very promising low-cost applications and devices, such as organic light-emitting diodes (OLED), organic solar cells, organic photodiodes, organic lasers and - as already mentioned - organic field-effect transistors. Organic materials can be tailored easily for optimized selectivity and sensitivity with respect to an analyte of interest. Therefore, organic-based devices such as OFETs are candidates for application as smart disposable sensor devices in health, food and environmental monitoring, diagnostics and control, ranging from light- and chemical vapor sensors to transducers for ions and biological substances. Furthermore, such devices can be integrated into textiles ("E-textiles") or into arrays of sensor elements for multi-species detection ("E-nose").

Aside from the common aforementioned advantages associated with the use of organic semiconductors, OFETs have a number of advantages related to their device architecture. In particular, compared to resistor-based sensors, field-effect transistors generally have the advantage of being more sensitive due to the inherent amplification of the sensing event. Moreover, they usually exhibit higher response times, higher sensitivity, low power consumption, the ability to implement multi-parameter sensing as well as the possibility to be integrated in complex circuits including signal processing.

In principle, an OFET resembles a capacitor with one plate providing a conducting channel between two ohmic contacts, the source and the drain electrodes. A voltage applied to the second plate, which is called the gate electrode, modifies the density of charge carriers in the channel. These carriers move from the source across the channel into the drain. Hence, just by applying a field across the dielectric layer the device is turned into its "on" or "off" state, respectively. Ideally, no current is needed for switching and so the corresponding power consumption is reduced (nearly) to zero.

Two architectures are widely used in the OFET fabrication: the so-called "bottom-gate structure" (or inverted staggered configuration) and the "top-gate structure" (or staggered configuration).

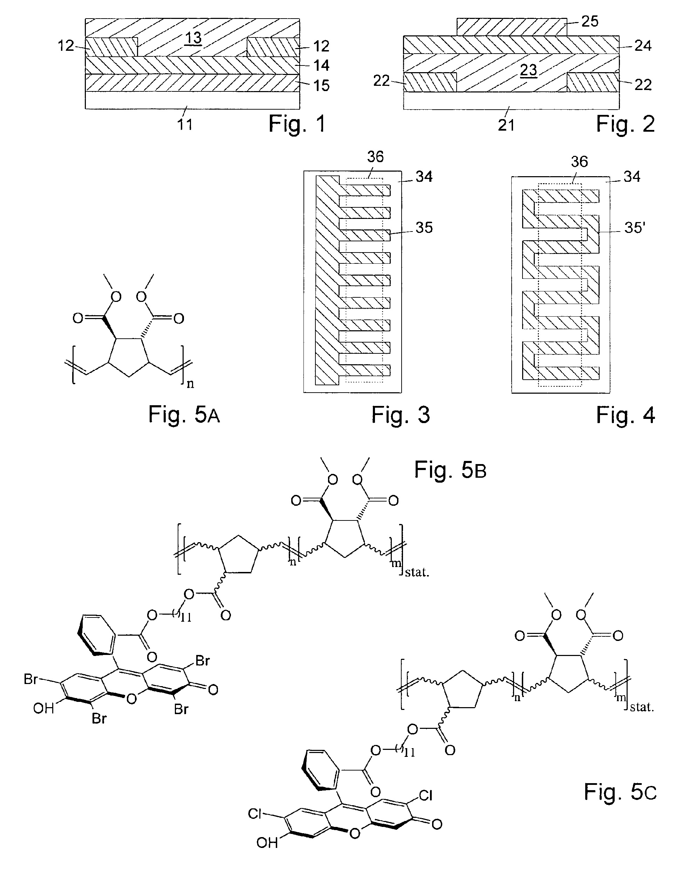

Fig. 1 shows a sectional view of an OFET with a bottom-gate architecture. On a substrate 11 a gate layer 15 serving as gate electrode is formed, for instance made of highly doped silicon or a conducting (doped) polymer such as PEDOT:PSS, which is then covered with a layer 14 of an appropriate dielectric material, for instance silicon dioxide or an organic compound such as PVA (polyvinyl alcohol) or PVP ( poly(vinylphenol), pure or cross-linked). This dielectric layer 14 is then covered with an organic semiconducting material 13 serving as active channel layer; moreover, two electrodes 12 (source and drain) may be provided on top ("bottom-gate/top-contact configuration"; not shown), or the organic semiconducting active layer 13 is in fact deposited after the definition of the source and drain electrodes 12 ("bottom-gate/bottom-contact configuration" as shown).

Fig. 2 illustrates the top-gate architecture, in which the source and drain electrodes 22 are located close to the substrate 21. The electrodes 22 are followed by the organic semiconducting material 23 serving as active channel layer. This active layer 23 is covered by a dielectric material 24, followed by the gate electrode 25 on top ("top-gate/bottom-contact configuration"). In an other subtype of this architecture, similar to the bottom-gate/top-contact configuration, the organic semiconducting material may be deposited before the definition of the source and drain electrodes so as to be located between these electrodes and the substrate ("top-gate/top-contact configuration", not shown).

Several intermediate layers, such as self-assembled monolayers for interface modification, layers to promote charge carrier injection or for other purposes, can be inserted in both configurations to improve the performance of a device.

Several sensors based on the OFET device have been demonstrated already and can be found in the state of the art. Examples are gas- or vapor-sensitive OFETs, mainly of bottom-gate type, for gases like N₂, O₂, NO₂, O₃ or organic vapors like alcohols, with the active semiconducting layer as sensing layer, whose conductivity is modulated upon interaction with an analyte; humidity-sensitive OFETs which show a reduction of the hole mobility by the presence of traps resulting from the polar water molecules; pH-sensitive (or ion-sensitive) OFETs based on inorganic dielectrics with an ion-sensitive surface, where the potential drop at the interface between the dielectric and an electrolyte solution is modified when the pH value changes in the latter; biochemical OFET-sensors e.g. for glucose, where a specific enzymatic layer is added to a pH-sensitive OFET; the enzyme leads to the formation of gluconic acid, which, upon dissociation, yields a change in the local pH value.

Moreover, organic transistor sensors with a layer of immobilized antibodies or DNA for the detection of the corresponding antigens or complementary target DNA have been proposed, in which direct charge transfer processes or charge displacements induced by complex formation lead to the sensor signal.

Generally, a key target in the field of OFET-based sensors is the establishment of completely solution-processed integrated devices with high selectivity, sensitivity and reproducibility.

OFET-based sensors as such are well-known in prior art. Known approaches of OFET-based sensors have been based on the following principles:
- using the semiconducting active layer (channel) as sensing layer, e.g. by a change in conductivity upon analyte interaction;
- providing a reactive dielectric surface in contact with an electrolyte for pH measurements (change in voltage drop near dielectric/electrolyte interface upon pH change), or addition of enzymatic layer for bio-sensing;
- providing an additional sensing layer, usually on top of the dielectric;
- using gate electrode as sensitive part.

For instance, WO 2007/138506 A1, discloses a field-effect transistor comprising a gate electrode layer, a first dielectric layer, a source electrode, a drain electrode, an organic semiconductor and a second dielectric layer above, wherein during operation of the field-effect transistor the capacitance of the assembly comprising the gate electrode layer and the first dielectric layer is lower than the capacitance of the second dielectric layer. Further a sensor system comprising such a field-effect transistor and the use of a sensor system for detecting molecules is disclosed with receptor molecules bond to the external outer surface of the second dielectric layer.

US 2007/0231790 A1 relates to a device and method for performing analyte detection, especially biomolecule detection. The device and method combine photo-induced charge separation in label materials and field effect transistors as sensors, resulting in more sensitive, specific and/or selective detections of biomolecules in multiplex assays, such as immunoassays and DNA microarray assays. The embodiments of the invention also encompass a device and method that comprise an array of electrical sensors, such as field effect transistors, and binding complexes for simultaneous multiplex detection of analytes.

The device described in JP 2007-178134 A comprises a flexible substrate having a reference electrode and a thin film transistor sensing element for ion concentrations formed on the substrate. An ion-sensitive film is stacked on the gate insulating film.

US 2004/001778 A1 (Chen et al.) presents a polarization-dependent device that includes organic materials having electric dipoles, based on a top-gate architecture with a dielectric layer on at least a portion of the channel region and a molecular layer on the dielectric layer, the molecular layer comprising molecules having a switchable dipolar moiety. By changing the polarity of the molecules within the molecular layer upon analyte interaction, the conductance of the active region between the source and drain is altered which can be detected.

A biosensor comprising an OFET and a method for its fabrication is described in US 2006/243969 A1, with a bottom-gate transistor including a transistor gate channel having a semiconductive film comprising organic molecules. Probe molecules capable of binding to target molecules are coupled to an outer surface of the semiconductive film such that the interior of the film being substantially free of the probe molecules. Target molecules binding to probe molecules result in a change of the electric field experienced by the semiconductor, which in turn modifies the current flow between source and drain.

An odor-sensitive organic transistor is disclosed in US 2002/117693 A1, in which the conductivity of the conduction channel changes in response to certain odors.

US 4,878,015 describes a sensor for the determination of liquid-phase or gas-phase components based on a top-gate MOSFET. The sensitive layer consisting of a heteropolysiloxane is applied to the inorganic gate dielectric layer, with a thin gold top-gate electrode or a gate metal layer consisting of aluminum in meander-like structure, both allowing the analyte to interact with the sensing layer.

### Summary of the invention

It is a goal of the present invention to apply the OFET device architecture for the fabrication of an active organic sensor device by integrating the functional units of an OFET in order to enable the manufacturing of cheap, integrated, reliable, sensitive and selective sensors.

The goal is met by an organic sensor of the type mentioned in the beginning, wherein the dielectric layer of the OFET is sensitive to at least one analyte contained in said medium, in that it includes (or is made of) an organic material sensitive to at least one analyte, said sensitive organic material being adapted to change its electronic properties upon contact with said analyte for generating a response which is electrically detectable through the organic field-effect transistor.

The invention provides a development of the OFET device architecture suitable for the fabrication of an active organic sensor device, in the following termed "SensFET", which is based on an appropriately designed/functionalized dielectric material being the active sensing matter.

The invention is primarily directed at gaseous or volatile analytes, which may be borne in a gaseous medium (for instance, as vapor) or transported by itself (then the analyte may represent the gaseous medium or one component of a mixture making up the gas or liquid). If a liquid medium is used, the analyte may be a dissolved substance.

The important achievement of the concept underlying the invention is the dielectric being directly used as the sensing layer. By virtue of this measure, problems when using the active organic semiconducting layer as sensing part are overcome. These problems include morphology variations in the organic semiconducting layer or batch-to-batch variations of the organic semiconductor material.

The invention exploits the potential of the gate dielectric to strongly determine the device behavior. In this context, S. Brandstätter, in his Diploma Thesis 2007, Graz University of Technology, showed that when water-soluble polyvinyl-alcohol (PVA) is used as gate dielectric material in an OFET, the device characteristics are largely affected by mobile ionic impurities contained within the material, resulting in a slow space charge polarization upon applying a gate voltage. While a bottom-gate/top-contact OFET comprising as-delivered, partially hydrolyzed PVA as gate dielectric revealed high gate leakage currents and a large amount of hysteresis in argon atmosphere, devices based on PVA purified by dialyzing the solution in bi-distilled water using an appropriate dialysis tube showed a clear absence of any hysteresis, which (also by FTIR spectra) was proven to result from the removal of mobile ionic impurities during dialysis.

Moreover, taking into account the top-gate architecture of the invention, the active semiconducting layer is protected against exposure to ambient atmosphere. Therefore materials for the semiconducting layer do not have to be stable with respect to ambient atmosphere.

The invention is in contrast to other sensor systems based on organic field-effect transistors which have been proposed earlier and where the sensing part is the active semiconducting layer or the interface between an electrolyte and a dielectric. The invention differs from these hitherto existing sensors by the sensing mechanism.

The core idea of the invention is a change in the dielectric behavior (dielectric function) of the gate dielectric when exposed to an analyte. In contrast to previous approaches of OFET-based sensors the present invention makes use of the gate dielectric bulk material to detect an analyte of interest. In particular, a sensor according to the invention can reversibly or irreversibly detect miscellaneous analytes (e.g. gases such as oxygen or ammonia, ions, bases, acids, olefins or aromatic compounds) contained in a gaseous or liquid medium by changing its electrical properties.

A sensor according to the invention may, for instance, resemble an OFET with a top-gate/bottom-contact structure (see Figure 2). The dielectric layer comprises a dielectric material that is sensitive to analytes. When exposed to the analyte, the OFET device reacts by a change of the absolute value of the source-to-drain channel current, the switch-on voltage, the threshold voltage or the magnitude of hysteresis, i.e. the area in a current-voltage characteristics framed by a forwardly and reversely recorded voltage curve. The gate electrode can be fabricated in a way that allows gaseous analytes to rapidly diffuse into the dielectric sensing layer.

Compared to a classical field-effect transistor sensor system based on inorganic materials such as silicon, OFET-based sensors offer the great advantage of using organic materials which can be tailored with respect to their chemical and physical properties. As a consequence, the sensing layer can be chemically tailored to enable or increase sensitivity and selectivity with respect to the analyte of interest.

Another advantage of OFET-based sensors is the fact that they enable low-cost production by using solution-based processing techniques such as inkjet printing.

While previous OFET-based sensors mainly centered on the active semiconducting layer operating as sensing layer, the present invention proposes an OFET sensor device with a sensing dielectric, combining the dielectric with the sensing feature. This reduces the fabrication effort of such a sensor element, making the application of any additional sensing layer obsolete. Moreover, encapsulation of the organic semiconducting layer, which is often sensitive to environmental influences such as oxygen and/ or moisture, is not necessary any more.

In order to match different analytes and applications, it is possible to tailor special sensing materials with exactly the properties needed. The invention also lends itself to applications for multiple analyte detection, by combining a number of SensFETs adapted for sensing different analytes into an array. When using solution-processable materials like polymers, efficient large-scale structuring techniques like inkjet-printing can be applied.

One preferred way to realize the organic field-effect transistor according to the invention is by way of a sandwich structure. Such structure may be composed of a sequence of layers located on a substrate, and the sequence of layers include an organic semiconducting layer realizing said channel, at least one sensitive layer realizing said dielectric layer, and a gate electrode.

In a further development of the invention, the structure may comprise additional organic or inorganic intermediate layers, in particular an intermediate layer located between the sensitive dielectric and the semiconducting layer or between the sensitive dielectric and the gate electrode, which may reduce/inhibit operational drift resulting from ions possibly present within the dielectric, serve as analyte-selective membranes, as layers for enhancing charge injection or serve other purposes supporting the sensor function.

In a suitable layout of the sensor according to the invention, the gate electrode may be laterally structured in a comb-like or meander-like shape, enabling direct contact of the gaseous or liquid medium with the dielectric layer. This measure will allow optimized access of the analyte to the organic dielectric layer.

As an alternative to structuring the gate electrode or in combination, the gate electrode may be permeable to the analyte. For applications where the analyte reaches the sensor from the substrate side, it is advantageous to configure the sensor such that for the bottom-gate architecture the substrate, the gate electrode and optional intermediate layers between gate electrode and sensitive dielectric are all permeable to the analyte, and for the top-gate configuration the substrate, source and drain electrodes, semiconducting layer and optional intermediate layers between organic semiconductor and sensitive dielectric are all permeable to the analyte. In such configurations, generally, the layers located between the dielectric layer and an accessing surface for the medium containing the analyte (i.e., the headspace of the sensor) are permeable to the analyte to allow diffusion of the analyte toward the dielectric layer.

Furthermore, the sensor device may comprise a semi-permeable membrane layer integrated anywhere within the layer system between the headspace of the sensor and the sensitive dielectric layer, which enables only the target analyte within a gaseous or liquid medium to reach the sensitive dielectric layer hence increasing the sensor's selectivity.

The sensor may be assembled on a rigid substrate or a substrate made of a flexible material so as to confer flexibility to the sensor. The substrate may be opaque, or it may be transparent, in particular if a light-induced interaction with the analyte-sensing mode is desired. The substrate and other layers between the headspace and the sensitive dielectric layer may be transparent, when the sensing event is based on a light-induced interaction so that light has to reach the sensitive dielectric layer, accordingly. In particular, the layers located between the dielectric layer and an illuminable surface are transparent; this illuminable surface may be oriented toward the headspace or opposite to it.

An advantageous embodiment of the invention concerns a sensor device (or sensor arrangement) assembled on a substrate, wherein the dielectric layer is covered by a semiconducting material realizing the semiconductor channel connecting the source and drain electrodes, the active semiconducting material - and possibly the source and drain electrodes as well - being permeable to the analyte.

According to a further aspect of the invention, the organic field-effect transistor is designed to change its current-voltage characteristics, such as absolute value of source-to-drain channel current, switch-on voltage, threshold voltage, and/or amount of hysteresis, upon exposure to an analyte of interest, wherein such change is evoked by a change of the electrical behavior of the dielectric layer.

Furthermore, the dielectric layer may be designed to allow for a dynamic or an accumulated response. In the case of dynamic response, the concentration of the target analyte will cause a sensor signal varying in correspondence with the analyte concentration, for instance in a proportional relation, while for an accumulated response the sensor signal would resemble the total integrated analyte concentration exposed to the sensitive dielectric layer so far.

In the simplest case, the dielectric layer is entirely made of the sensitive organic material. Alternatively, only a region of the dielectric layer may include or be made of this sensitive organic material; this region will suitably be located in a corresponding manner to the active semiconductor channel and, thus, extend over an area corresponding to at least a (major) part of the active semiconductor channel.

In a sensor according to the invention, the dielectric layer may be made of a variety of materials, of which the following materials and derivatives of them are noteworthy:
a. BCB = divinyltetramethyldisiloxane-bis(benzocyclobutane);
b. PMMA = poly(methylmetacrylate);
c. PVA = poly(vinylalcohol);
d. PVP = poly(vinylphenol) (pure, cross-linked);
e. a polymeric material based on a poly(acrylate), poly(methacrylate), poly(acrylamide), poly(vinylether), poly(olefine), poly(norbornene), poly(7-oxanorbornene) or poly(styrene) backbone comprising a substituent R which is prone to interact with acidic or alkaline reactants; the structure of these compound is illustrated in Formula 1a to 1h: 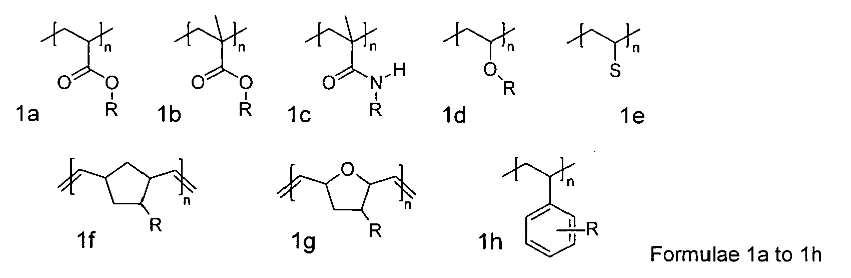 wherein special, noteworthy cases of the substituent R are:
   R = H;
   R = (CH₂)ₘ-OH (m = 2 - 10), (CH₂)ₘ-COOM (m = 2 - 10, M = H, Li, Na, K),
      (CH₂)ₘ-SO3M (m = 2 - 10, M = H, Li, Na, K) or
      (CH₂)ₘ-NR'R" (m = 2 -10, R' = H, Alkyl; R" = H, Alkyl);
   R = OH, COOH, O(CH₂)ₘ-OH (m = 2 - 10),
      O(CH₂)ₘ-COOM (m = 2 - 10, M = H, Li, Na, K),
      O(CH₂)ₘ-SO3M (m = 2 - 10, M = H, Li, Na, K),
      O(CH₂)ₘ-NR'R" (m = 2 - 10, R' = H, Alkyl; R" = H, Alkyl);
   R = COO(CH₂)ₘ-OH (m = 2 - 10),
      COO(CH₂)ₘ-COOM (m = 2 -10, M = H, Li, Na, K),
      COO(CH₂)ₘ-SO₃M (m = 2 - 10, M = H, Li, Na, K),
      COO(CH₂)ₘ-NR'R" (m = 2 -10, R' = H, Alkyl; R" = H, Alkyl);
f. a polymeric material as cited in item (e) which is incorporated into a copolymer including the said functional group;
g. a polymeric material as cited in item (e) or (f), which is blended into another polymeric material;
h. an ion-sensitive polymeric material containing crown-ether and/ or cryptands as functionalized sensitive part.

Moreover, dielectric copolymers as well as blends of the aforementioned materials may be used as well.

Furthermore, a particularly useful application of the invention is a sensor device comprising a plurality of sensors according to the invention. According to this aspect, the invention lends itself to the construction of a sensor device comprising a plurality of sensors according to the invention, with the individual sensors adapted to detect different species of analytes, respectively. These individual sensors may be realized with a common dielectric material which is modified individually realizing a corresponding plurality of dielectric layers having different analyte sensing functionalities.

### Brief description of the drawings

In the following, the present invention is described in more detail with reference to several exemplary embodiments which are illustrated in the drawings, namely:
- Fig. 1: illustrates the basic architecture of a bottom-gate OFET-based sensor in a schematic sectional view;
- Fig. 2: illustrates the basic architecture of a top-gate OFET-based sensor in a schematic sectional view;
- Fig. 3: shows a schematic top view of a top-gate electrode having a comb-shaped structure;
- Fig. 4: shows a schematic top view of a top-gate electrode having a meander-shaped structure;
- Figs. 5A to 5C: show the chemical structures of exemplary dielectric materials used to realize sensors according to the invention;
- Fig. 6: shows a schematic cross-section of a first embodiment of a SensFET according to the invention;
- Fig. 7: is a top view of the SensFET of Fig. 6;
- Figs. 8A and 8B: show UV/Vis absorption spectra of a reference ROMP film (Fig. 8A) and a ROMP film with eosin as active functionalized unit (Fig. 8B);
- Fig. 9: shows the output characteristics of the SensFET device of Figs. 6 and 7 before analyte exposure;
- Fig. 10: shows the transfer characteristics of the SensFET device of Figs. 6 and 7 before analyte exposure;
- Figs. 11A to 11C: show the time-dependent behavior of the SensFET device of Figs. 6 and 7 upon exposure to an analyte (ammonia);
- Fig. 12: shows the output characteristics of the SensFET device of Figs. 6 and 7 after exposure to 1 % ammonia;
- Fig. 13: shows the transfer characteristics of the SensFET device of Figs. 6 and 7 after exposure to 1 % ammonia;
- Fig. 14: shows transfer curves of several SensFET devices according to the invention before and after exposure to 1 % ammonia;
- Fig. 15: illustrates an example of a top-gate OFET-based sensor structure comprising a semi-permeable membrane and an intermediate layer, both enhancing the sensing behavior of the SensFET;
- Fig. 16: shows schematically the top-view of a multiple sensor array comprising four SensFET devices, each with a dielectric layer material sensitive to an individual analyte.

### Detailed description of the invention

In the following, the present invention is described in more detail with reference to the drawings. Of course, the invention is not restricted to the embodiments described hereinafter, but extends to all realizations which the person skilled in the art may find within the scope of the claims.

For producing a sensor structure according to the invention, common OFET production technology may be used. In particular, the organic materials in an OFET according to the invention may be solution-processed (e.g. spin-cast, inkjet-printed) or vapor deposited; and the substrate material can be both rigid (e.g. glass, silicon) or flexible (e.g. PET, Mylar). However, certain modifications are required in comparison to a common OFET, in order to allow sufficient interaction between the analyte and the sensing layer. This is achieved by suitable measures such as providing layers with a specific shaping (e.g. comb-shaped or meander-shaped) or using analyte-permeable materials for the electrodes, substrate, semiconducting layer and/or optional intermediate layers. When solution-processed, it is advantageous to apply the individual layers using orthogonal solvents or appropriate curing procedures so that already deposited layers are not dissolved by succeeding layer deposition.

The applied organic materials are preferably chosen with regard to the relevant application so as to ensure that the dielectric sensing material is sufficiently sensitive and selective for the analyte of interest.

In order to generate the gate, source and drain electrodes, suitable methods of the state of the art can be used, such as vapor deposition, sputtering, lamination, a (soft) lithographic process or an inkjet-print method.

In the context of the present invention the sensing functionality is a key property of the dielectric layer of the device, which should be considered when determining the sensor architecture. The specific sensing functionality is provided by appropriate chemical design of the dielectric material or by blending a dielectric material (host) with sensing molecules (guest). The dielectric properties of the dielectric layer are dependent on the presence and the amount of the analyte in the medium present in the headspace of the sensor.

In detail, when exposed to the target analyte, the dielectric material will undergo certain specific reactions, such as direct charge transfer processes between the analyte and the dielectric, charge displacements induced by complex formation and/or the generation of moving ions within the gate dielectric. These processes result in a modification of its electrical properties, which in turn yields changes in the electric characteristics of the SensFET, including variations in the absolute value of the source-to-drain channel current, the switch-on voltage and/or the threshold voltage and/or the amount of hysteresis.

The invention makes it possible that, depending on the material used in the dielectric sensing layer, analytes of volatile/gaseous nature can be detected. When a liquid medium is used, the analyte may be a dissolved substance as well. This includes, but is not limited to, specific molecules such as oxygen, ammonia, nitrogen, carbon monoxide or carbon dioxide, moreover ion-containing materials and substances with specific chemical properties such as acidic substances (proton donators), in particular acidic gases, or basic/alkaline substances (proton acceptors), in particular basic gases, or substance groups such as olefins or aromatic compounds. Also biomolecules may be target analytes.

Furthermore, the invention includes sensor arrays composed of sensors of the described types, containing a plurality of (different) sensor molecules forming the dielectric, which can be used to detect an assortment of different analytes simultaneously.

The sensing event, i.e. the measurable effect that the sensor exhibits upon contact with the appropriate analyte, may be reversible or irreversible. Reversibility is obtained by applying suitable procedures which refresh the contaminated sensor. For instance, with a sensor for oxygen sensing, oxygen absorbed in the course of a sensing event may be removed e.g. by heating the sensor, or by storing it in a vacuum chamber, which will restore the pristine state of the sensor and thus its initial characteristics (in terms of absolute value of one or more relevant electric characteristic quantities). A similar approach works for the restoration of a sensor for acidic or alkaline gaseous analytes; exposure to an alkaline gas will refresh a sensor that has reacted to an acidic gas, and vice versa.

Even if the sensing event cannot be reversed, the sensor can still find an application as disposable, single-use device.

As already mentioned, the organic layers in the SensFET device according to the invention may be applied via solution processing (e.g. spin-coating, inkjet-printing) or vapor deposition. The dielectric layer is not limited to one single film - it may be realized as a composite layer consisting of one or more dielectric layers.

Advantageously, all the materials that constitute the sensor according to the invention, other than those of the sensing dielectric layer, are insensitive to the analyte. Moreover, they should be inert to other substances that the sensor will get into contact with during normal operation. This will ensure that the sensor response upon exposure to the analyte in the headspace originates solely from the reaction/interaction of the sensing material with the analyte.

The sensors according to the invention may be based on the bottom-gate or top-gate architecture illustrated in Figs. 1 and 2, with the dielectric layer 14, 24 realized as sensitive layer as described in this disclosure.

In the bottom-gate case (Fig. 1), the substrate 11 and the gate electrode 15 can be made of analyte-permeable materials or realized as a permeable structure comprising appropriate channels for analyte diffusion from the substrate side. Alternatively, the sensor may be designed such that the analyte of interest diffuses from the direction of the organic semiconducting layer 13 to the dielectric 14; in this case, an analyte-permeable material is chosen for the layer 13. Hence, either the space above layers 12 and 13 (diffusion from organic semiconductor side) or that below layers 11 and 15 (diffusion from substrate side) serves as headspace for the medium to be sensed for the presence of an analyte by the active dielectric material. As already mentioned, the source and drain electrodes might also be deposited after the deposition of the organic semiconductor, yielding a SensFET based on the bottom-gate/top-contact OFET architecture (not shown).

In a variant to the architecture shown in Fig. 1, a bottom-gate SensFET device may further include one or more additional layers such as an intermediate layer, positioned in particular between the sensitive dielectric 14 and the organic semiconductor 13. Such intermediate layer may be, for instance, made of an organic material or an inorganic oxide. An intermediate layer may be advantageous in case such as where the two latter materials exhibit solvent incompatibility being based on the same solvent, or to block unwanted ions possibly present within the dielectric moving during operation and causing drift or for other reasons enhancing the performance of the device. Furthermore, a semi-permeable membrane material might be added anywhere between the headspace of the sensor device and the sensitive dielectric layer for increasing selectivity.

In a top-gate type sensor (Fig. 2), in order to allow or enhance analyte diffusion from the top side to the dielectric 24, the gate electrode material may be made of a material permeable to, but not interacting with, the analyte and based on either organic or inorganic materials. Alternatively or in combination, analyte diffusion from the substrate side to the active sensing dielectric layer 24 could be provided for by realizing the substrate 21, the organic semiconductor 23 and possibly also the source and drain electrode material 22 as analyte-permeable materials or employing a permeable structure comprising appropriate channels for analyte diffusion. Hence, the space above the layer 25 (diffusion from top-gate side) or that below layers 21, 22 and 23 (diffusion from substrate side) may serve as headspace for the medium to be sensed for the presence of an analyte by the active dielectric material. In a variant, the source and drain electrodes may also be generated (e.g., deposited) after the deposition of the organic semiconductor layer 23, yielding a SensFET based on the top-gate/top-contact OFET architecture.

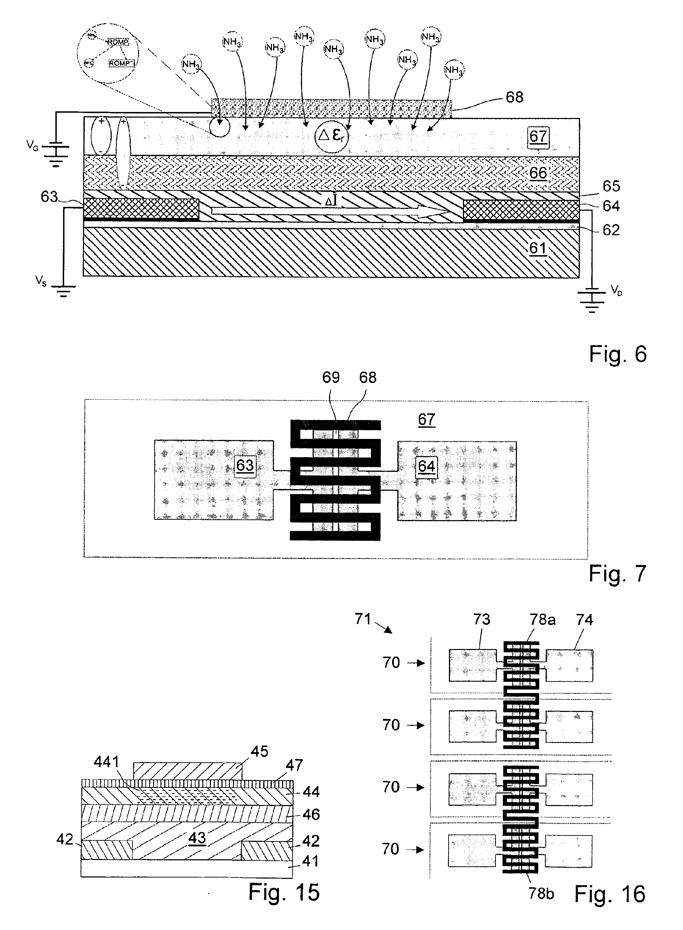

In a further aspect, top-gate SensFET devices may also include one or more additional layers, such as an intermediate layer (e.g. made of an organic material or an inorganic oxide; not shown in Figs. 1 and 2, but see reference 62 in Fig. 6) between the sensitive dielectric 24 and the organic semiconductor 23. An intermediate layer may be, for instance, advantageous when the materials of the adjacent layers exhibit solvent incompatibility (since they are based on the same solvent) or in order to block unwanted ions, which are present within the dielectric moving during operation and causing drift or for other reasons enhancing the performance of the device. Also a layer based on a semi-permeable membrane material might be added anywhere between the headspace of the sensor device and the sensitive dielectric layer for increasing selectivity.

Besides being made of an analyte-permeable material, the top-gate electrode in the top-gate SensFET structure can also be structured suitably to allow for direct interaction between the analyte and the active sensing dielectric layer. As shown in Fig. 3, the top-gate electrode 35 may be structured in a comb-like shape. This presents the sensing dielectric layer 34 directly to the surface, exposing it to the analyte, in particular over channel region 36 of the SensFET. (The drain and source electrodes, not explicitly shown in Figs. 3 and 4, extend to the left and right of the channel region 36.)

Fig. 4 illustrates another possible approach of structuring the top-gate electrode to allow for direct interaction of the analyte with the active sensing dielectric. The top-gate electrode 35' is structured in a meander-like shape, so the sensing dielectric layer 34 is again directly exposed to the analyte, in particular over the SensFET channel region 36.

The main advantage of the structuring of the gate electrode as depicted in Figs. 3 and 4 is the reduced response time of the system, as the active dielectric layer is directly exposed to the analyte, thus disposing with an indirect analyte penetration, namely, penetration through various inactive layers to get to the active dielectric layer.

Of course, the various embodiments shown here can be combined freely. In particular, the top-gate structures shown in Figs. 3 and 4 may also be combined with additional layers such as an intermediate layer as explained above.

An example of a possible OFET realization is a comb-shaped (or meander-shaped) top-gate electrode made from aluminum combined with a solution-processed gate dielectric made from PVA; n⁺⁺-Si/SiO₂ was used as substrate, Au for source/drain electrodes, and P₃HT (poly(3-hexylthiophene)) as organic semiconducting material. Such devices exhibit comparable performance to top-gate OFETs with a solid-shaped rectangular gate electrode, hence proving the possibility to adapt this structure for the SensFET.

Another example, discussed in detail in the following with reference to Figs. 6 and 7, is a SensFET for ammonia-sensing based on a dual layer, comprising a sensitive functionalized ROMP material (ring opening metathesis polymer) and PVA, as gate dielectric.

Fig. 6 shows the configuration of the layers of the SensFET for ammonia-sensing, in a schematized cross-sectional detail encompassing the channel region and adjacent portions of the source and drain electrodes. Fig. 7 illustrates a top view of the SensFET. The SensFET is realized in a sandwich configuration of consecutive layers, with: a substrate 61 made of n⁺⁺-Si having a thermally evaporated, 200 nm thick SiO₂ covering layer 62; source and drain electrodes 63, 64 realized as photolithographically structured 50 nm thick gold electrodes (with a 2 nm thick chromium layer as adhesive layer); an organic semiconducting layer 65 made of P₃HT spin-cast from CHCl₃-solution covering the substrate 61, 62 including the electrodes 63, 64; a dialyzed polyvinylalcohol intermediate layer 66 which is also produced by spin-cast from solution; a dielectric layer 67 made of an active-sensing ROM-polymerized material (spin-cast from CHCl₃ solution); and a meander-shaped structured top-gate electrode 68 made from 100 nm thick, thermally evaporated aluminum. PVA was applied as intermediate layer material for solution-compatibility reasons, since both the organic semiconducting material and the applied active sensing ROMP could only be dissolved in organic solvents, while PVA is water-based. This helps to avoid the risk that without this intermediate layer, P₃HT may be dissolved again during the deposition of the ROMP, which would jeopardize proper functioning of the device. The length of the channel region 69 (distance between drain and source electrodes) is 25 µm, its width 2.85 mm.

As will be obvious to the person skilled in the art, the thickness of the layers will depend on the individual realization and intended application of the sensor. The thickness of the dielectric layer will be chosen sufficiently small so as to ensure sufficient diffusion of the analyte on one hand while on the other hand, a thick dielectric layer entails the risk of pinholes and leakage currents. Therefore, the dielectric layer is typically about 50 -100 nm minimum, and may be up to a several times this value, for instance 500 nm to 2000 nm. Regarding the organic layer serving as channel layer, the charge transport will take place within the first few monolayers close to the interface with the dielectric layer; therefore, typical values of the thickness of the channel layer are 10-50 nm. In the device of Figs. 6 and 7, the semiconducting active layer 65 had a thickness of 15-20 nm, and the electrodes 63, 64 had a thickness of about 50 nm, but could be 30 or 100 nm thick as well. Since the electrodes 63, 64 usually have a considerable thickness, they will often cause a buckling of the upper boundary surface of the active layer 65 (i.e., the interface to the next layer, in this case layer 66) and possibly of the subsequent layers as well; such buckling is not shown in the drawings.

The chemical structures of the tested dielectric materials are shown in Figs. 5A to 5C. While the ROM-polymerized dimethylester-homo-polymer (Fig. 5A; n = 300) was used as not-functionalized dielectric reference material, two active-sensing ROMP materials were applied, namely a ROM-polymerized statistical copolymer with eosin as functionalized group (Fig. 5B; 1 mol-%, functionalized NH₃-sensitive dielectric material; m = 300, n = 3) and a ROM-polymerized statistical copolymer with 2,7-dichlorfluorescein as functionalized group (Fig. 5C, 1 mol-% functionalized NH₃-sensitive dielectric material; m = 300, n = 3). The sensor signal obtained from the active-sensing ROM-polymers is based on the fact that a deprotonating gas such as NH₃ captures the hydrogen atom of the OH-group in the polymer, thus creating mobile NH₄⁺ ions and inducing a dipolar polarization leading to a change of the dielectric behavior, as symbolically indicated in the upper left corner of Fig. 6.

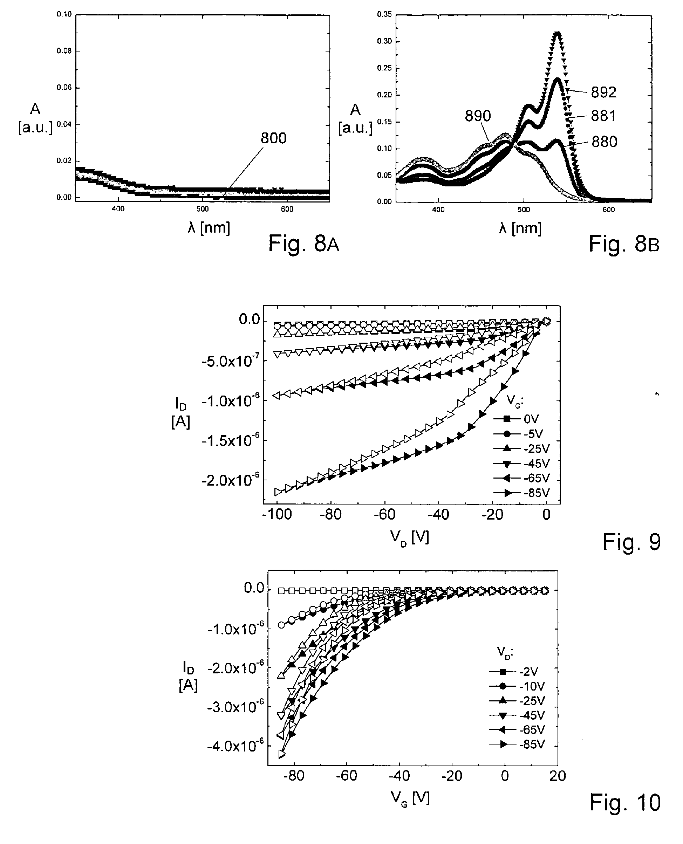

Figs. 8A and 8B give a comparison of the UV/Vis absorption spectra (absorption A as function of the wavelength λ [Greek letter 'lambda']) between a reference ROMP film and a sensitive ROMP film. Both films were produced by spin-casting from solution onto a glass substrate. Fig. 8A shows the spectrum 800 of the reference ROMP film based on the material shown in Fig. 5A. In contrast, Fig. 8B shows spectra 880,881,890,892 of a ROMP film with eosin as active functionalized unit (chemical structure in Fig. 5B), wherein the curve denoted 880 is the spectrum of the film as prepared; the curve 881, after a first exposure to 100% ammonia for 30 min; the curve 890, after an exposure to HCl for 1 min (recovery); and the curve 892, after a second exposure to 100% ammonia for 30 min. For the reference ROMP film, a set of spectra at different stages of treatment as with the sensitive ROMP film (Fig. 8B) were taken as well, but in line with expectation, all those spectra were found to coincide into one spectrum 800 which is shown in Fig. 8A. Clearly observable is the change of the absorption spectrum of the active-sensing ROM polymer when exposed to ammonia as deprotonating and HCl as protonating gas. The corresponding spectrum of the reference polymer remains unchanged.

Figs. 9 and 10 show the output and transfer characteristics (i.e., source-to-drain current I_{D} as a function of drain-source and gate-source voltages V_{D} and V_{G}) of the SensFET device shown in Figs. 6 and 7 before analyte exposure. Filled symbols denote sweeps from positive to negative voltage values, while open symbols denote reverse sweeps.

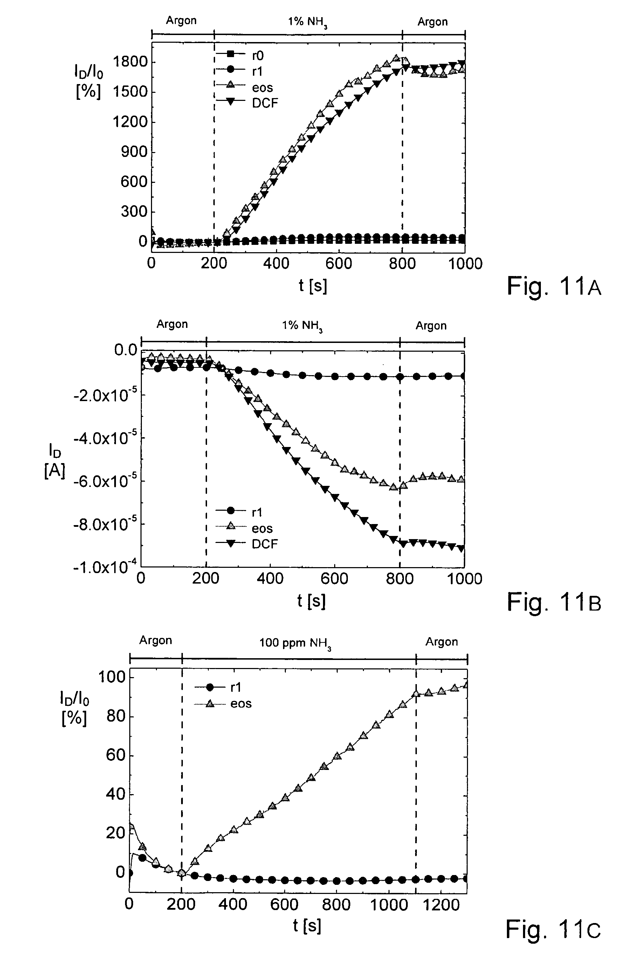

Figs. 11A to 11C illustrate the sensor reaction upon exposure to an analyte (here: ammonia, NH₃). Depicted is, as a function over time t (in seconds), a sensor reaction, in the form of either a normalized sensor signal I_{D}/I₀ (normalized time-dependent source-to-drain channel current; in percent) or the current I_{D} without normalization. The different curves in each frame relate to a sequence of top-gate/bottom-contact SensFET devices having meander-shaped top-gate electrode, and realized with different dielectric materials: r0 = PVA solely, r1 = PVA/reference polymer without any functionalized group, eos = PVA/ROM-polymer with eosin as active functionalized group, DCF = PVA/ROM-polymer with dichlorfluorescein as active functionalized group.

Fig. 11A depicts the sensor signal I_{D}/I₀ of the devices exposed to argon (inert gas), then 1 % ammonia, then argon again. While the reference devices r0, r1 showed little response to NH₃, both ROMP devices with eosin and dichlorfluorescein exhibited a distinct source-to-drain-current increase of about 1800 %. Fig. 11B depicts the corresponding (not-normalized) source-to-drain channel current behavior I_{D}. As I_{D} remains rather unchanged after stopping the analyte exposure, these SensFET devices are proposed as examples for single-use sensors. Fig. 11C indicates that it is easily possible to detect ammonia concentrations of 100 ppm with such a SensFET device.

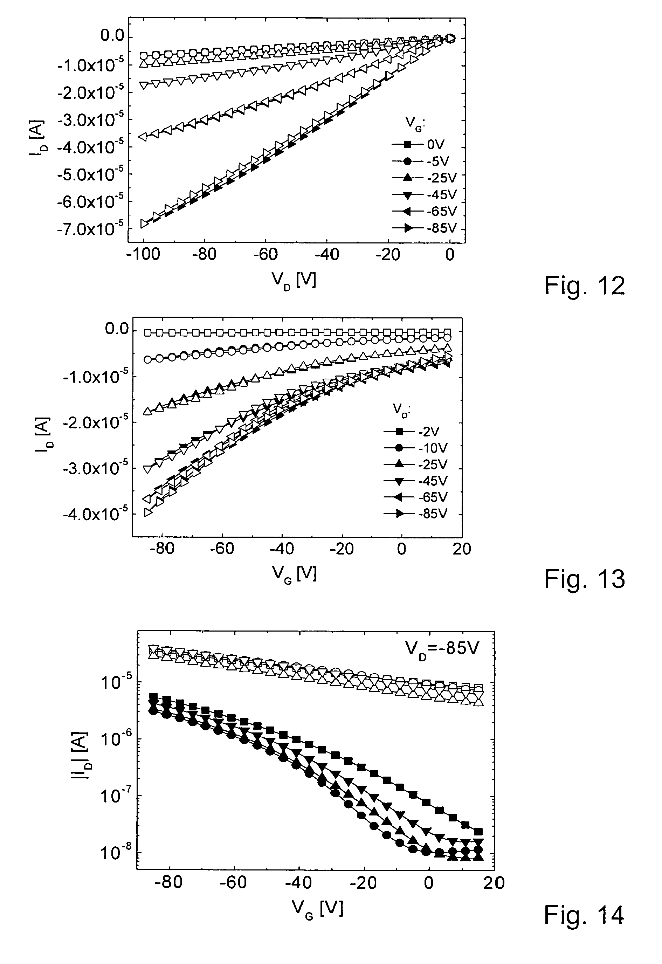

Figs. 12 and 13 show the output and transfer characteristics of a SensFET device as shown in Figs. 6 and 7 after exposure to 1 % ammonia. Figs. 12 and 13 correspond to Figs. 9 and 10, respectively, but note the different scales of the voltages. A clear difference (e.g. in terms of on-current, off-current, switch-on voltage) is observable as compared to before ammonia exposure (Figs. 9 and 10), resulting from the interaction between the analyte and the active-sensing gate dielectric material.

Fig. 14 shows transfer curves of a group of SensFET devices based on the Eosin-ROM-polymer before (closed symbols) and after (open symbols) exposure to 1 % ammonia, in a semilogarithmic representation. The curves show good agreement which demonstrates the reproducible sensing behavior for the sample.

In a further aspect of the invention a membrane based on a semi-permeable membrane material helps determining the analyte specificity of the sensor. Such a semi-permeable layer may be added anywhere between the headspace of the sensor device and the sensitive dielectric layer for increasing selectivity, such as one of the surfaces of the sensor or an interface between two adjacent layers.

Referring to Fig. 15, a sensor of top-gate architecture is accessed from the gate side (i.e., the headspace is the space located in the figure above the substrate). A semi-permeable membrane 47 is located between the headspace and the dielectric layer 44, in this case also between the gate 45 and the dielectric layer 44, allowing diffusion only for a selected analyte. Also shown is an intermediate layer 46 separating the dielectric layer 44 from the active channel layer 43 and source and drain electrodes 42. In the alternative case where the headspace is at the substrate side (the space below the sensor shown in Fig. 15), the semi-permeable layer may be located in place of the intermediate layer 46 in Fig. 15, or at any other interface between the layers below the dielectric layer 44.

Fig. 15 also illustrates another development of the invention, namely that only a portion 441 of the dielectric layer 44 is realized with the sensitive material, while the other parts of the dielectric layer are formed differently. For instance the sensitive portion 441 may be implemented using one of the sensitive materials illustrated in Fig. 8B, whereas the rest of the dielectric layer is made of the base material used as reference material in Fig. 8A. The shaping of the sensitive portion 441 can be made by structuring processes known in prior art, similar to those used for structuring the electrodes. In a further variant, the sensitive portion of the dielectric layer could be structured in the same way as the gate electrode 45.

Fig. 16 shows a top view of a composite sensor device 71, comprising four sensors 70 arranged side by side, each possibly comprising a dielectric layer material sensitive to an individual analyte hence realizing a simple "E-nose". The individual sensors 70 may share some of the sensor components, as illustrated by the gate electrodes 78a, 78b, which are shared by two sensors respectively, but each sensor of a sensor pair has its own pair of source and drain electrodes 73, 74.

## Claims

1. A sensor for detecting an analyte of interest in a gaseous or liquid medium, comprising an organic field-effect transistor comprising a semiconductor channel connecting a source electrode and a drain electrode, and further comprising a gate electrode which is separated from said channel by a dielectric layer, wherein the dielectric layer includes an organic material sensitive to at least one analyte contained in said medium, said sensitive organic material being adapted to change its electronic properties upon contact with said analyte for generating an electrically detectable response in the organic field-effect transistor.

2. Sensor according to claim 1, wherein the organic field-effect transistor is realized in a sandwich structure composed of a sequence of layers located on a substrate, said sequence of layers including an organic semiconducting layer realizing said channel, at least one sensitive layer being made of said sensitive organic material and realizing said dielectric layer, and a gate electrode.

3. Sensor according to claim 2, the sandwich structure further comprising at least one additional intermediate layer located between the semiconducting layer and at least one of the sensitive layer and the gate electrode.

4. Sensor according to any one of claims 1 to 3, wherein the gate electrode is laterally structured in a comb-like or meander-like shape, enabling direct contact of the gaseous or liquid medium with the dielectric layer.

5. Sensor according to anyone of claims 1 to 4, wherein the layers located between the dielectric layer and an accessing surface for said medium are permeable to the analyte.

6. Sensor according to any one of claims 1 to 5, further comprising a semi-permeable membrane located at a layer interface between an accessing surface for said medium and the dielectric layer.

7. Sensor according to any one of claims 1 to 6, being assembled on a flexible substrate, preferably a flexible transparent substrate.

8. Sensor according to any one of claims 1 to 7, wherein the layers located between the dielectric layer and an illuminable surface are transparent.

9. Sensor according to any one of claims 1 to 8, wherein the organic field-effect transistor is designed to change its current-voltage characteristics, such as absolute value of source-to-drain channel current, switch-on voltage, threshold voltage, and/or amount of hysteresis, upon exposure to an analyte of interest, this change being evoked by a change of the dielectric constant of the dielectric layer.

10. Sensor according to any one of claims 1 to 9, wherein the dielectric layer is designed to allow for an accumulated response.

11. Sensor according to any one of claims 1 to 10, wherein a region of the dielectric layer includes said sensitive organic material, said region extending over an area corresponding to at least a part of said semiconductor channel connecting the source and drain electrodes.

12. Sensor device comprising a plurality of sensors according to any one of claims 1 to 11, the sensors being adapted to detect different species of analytes, respectively.

13. Sensor device according to claim 12, wherein the sensors are realized with a common dielectric material which is modified individually realizing a corresponding plurality of dielectric layers having different analyte sensing functionalities.
